# EUROPEAN PATENT APPLICATION

(11) **EP 4 651 671 A1**
(43) Date of publication of application: **19.11.2025**
(21) Application number: 25315148.4
(22) Date of filing: 30.04.2025
(51) Int. Cl.: H10D 30/66, H10D 30/01, H10D 64/00, H10D 84/00, H10D 8/00

(54) **TRANSISTOR POWER DEVICE WITH INTEGRATED DIODE TEMPERATURE SENSOR**

(30) Priority: 16.05.2024 IT 202400011107
(71) Applicant: STMicroelectronics International N.V., 1228 Plan-les-Ouates, Geneva (CH)
(72) Inventor: Novarese, Adriano Pietro, 95030 Mascalucia (CT) (IT); Pirnaci, Massimo Davide, 95028 Valverde (CT) (IT); Masoero, Lia, 13006 Marseille (FR)
(74) Representative: Studio Torta S.p.A.

(57) **Abstract**

A transistor power device (1) is disclosed, provided with: a substrate (2), having a front surface (2a) with extension in a horizontal plane (xy) and a rear surface (2b), opposite with respect to the front surface along a vertical axis (z); at least a first trench (4), which extends within the substrate, a gate region (6), of a conductive material, being arranged in a surface portion of the first trench; at least a second trench (14), which extends within the substrate, parallel to the first trench, a first conductive region (18) being arranged at a surface portion of the second trench, wherein at least a first surface portion (18a) of the first conductive region is doped with a first conductivity type (n) and at least a second surface portion (18b) of the first conductive region is doped with a second conductivity type (p), to respectively define a cathode terminal and an anode terminal of a diodeelement (32), integrated in the second trench. A protection element (40), of a conductive material, is integrated within the second trench, arranged between the first conductive region and the substrate, forming a shield element for the diode element (32) with respect to the substrate (2).

## Description

### TECHNICAL FIELD

The present solution relates to a semiconductor power device, in particular a transistor device, having an integrated temperature sensor, in particular made by a diode element.

### BACKGROUND

There is a known need in electronic devices or systems, in particular for analog power applications, to implement temperature monitoring, in order to control and improve the operation of the same electronic devices or systems.

In particular, the use of diodes as temperature sensing elements is known, wherein the substantially linear dependence on temperature of a corresponding forward biasing voltage is exploited.

In this regard, US 2023/0134063 A1 describes a known solution of a power device, in particular of the trench-gate field-effect transistor type, where a diode element for temperature sensing is formed within a respective trench.

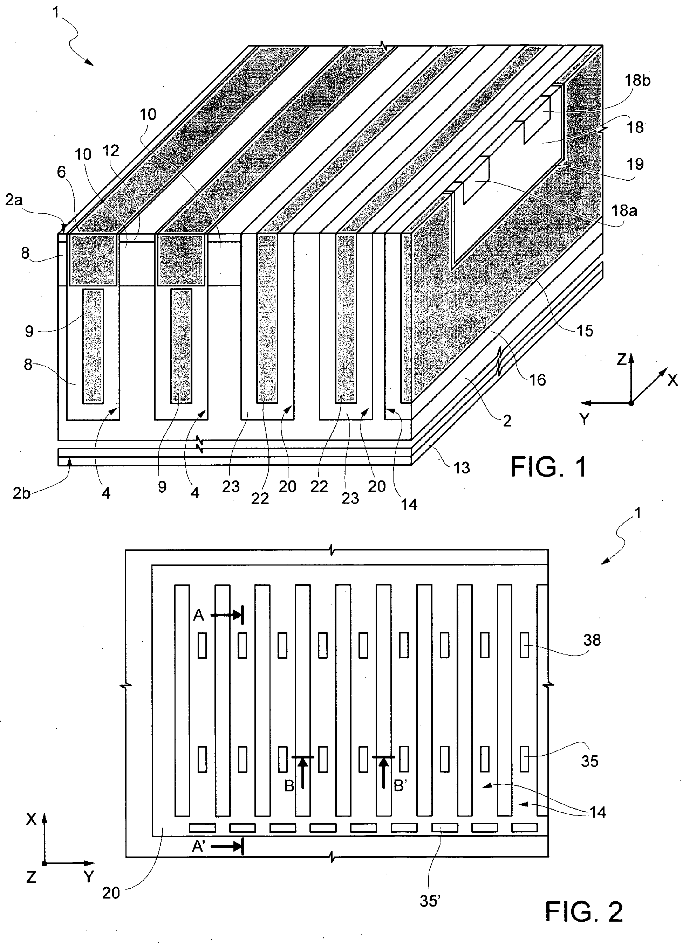

Referring to Figure 1, this power device, generally denoted by 1, comprises a substrate 2 of semiconductor material, for example silicon, having a front surface 2a with extension in a horizontal plane xy and a rear surface 2b, parallel to the front surface 2a and opposite with respect to the same front surface 2a along a vertical axis z, transversal to the horizontal plane xy.

The power device 1 comprises first trenches, in particular gate trenches 4, which extend starting from the front surface 2a within the substrate 2 in the direction of the vertical axis z and have a longitudinal main extension along a first horizontal axis (denoted as the axis x in Figure 1) of the horizontal plane xy.

A surface portion of these gate trenches 4 is occupied by gate regions 6, of conductive material, in particular polysilicon, which are part of respective transistor cells of the power device 1.

These gate regions 6 are separated from the substrate 2 by an insulating layer 8, in particular of a dielectric material, which coats the internal walls of the gate trenches 4; this insulating layer 8 has a first thickness, that is smaller, at the aforementioned surface portion of the gate trenches 4 (where it defines the gate oxide of the transistor cell), and a second thickness, that is greater, at a deep portion of the same gate trenches 4, underlying the surface portion with respect to the vertical axis z.

Conductive regions 9, so-called "field-plate" regions, made of polysilicon, placed below the gate regions 6 and electrically insulated from the same gate regions 6, are located within the aforementioned deep portion of the gate trenches 4, internally to the insulating layer 8.

The power device 1 further comprises, for each transistor cell: body regions 10, having a first conductivity type, for example p-type, arranged laterally to the gate trenches 4, in proximity to the front surface 2a of the substrate 2; and source regions 12, having a second conductivity type, for example n-type, arranged within the body regions 10, at the same front surface 2a.

Suitable contact elements (here not illustrated) electrically contact the gate regions 6 and the source regions 12 of the transistor cells, defining gate and source terminals of the power device 1.

Furthermore, at the rear surface 2b of the substrate 2, the power device 1 comprises a conductive layer 13 which represents a drain terminal for the same power device 1.

This power device 1 also comprises second trenches, in particular diode trenches 14, which extend starting from the front surface 2a within substrate 2 in the direction of the vertical axis z and also have a longitudinal main extension along the first horizontal axis x of the horizontal plane xy, parallel to the gate trenches 4.

These diode trenches 14 are filled at the bottom by a filling conductive region 15, in particular of polysilicon, which is separated from the substrate 2 by a first insulating layer 16, for example of silicon oxide or silicon nitride, which internally coats the lower and lateral walls of the same diode trenches 14.

A diode conductive region 18, also of polysilicon, is arranged internally with respect to the aforementioned filling conductive region 15, 'at the front surface 2a, being separated from the same filling conductive region 15 by a second insulating layer 19, for example also of silicon oxide.

In particular, first surface portions 18a of the aforementioned diode conductive region 18 are doped with a first conductivity type doping (n); and second surface portions 18b of the same diode conductive region 18 are doped with a second conductivity type doping (p), so as to respectively define a cathode terminal and an anode terminal of a diode element, integrated in a respective one of the aforementioned diode trenches 14.

In detail, the aforementioned first and second surface portions 18a, 18b of the diode conductive region 18 are aligned along the first horizontal axis x and are separated along the same first horizontal axis x by a separating surface portion of the same diode conductive region 18.

As shown in the same Figure 1, the power device 1 further comprises third trenches, in particular separation trenches 20, which extend starting from the front surface 2a within the substrate 2 in the direction of the vertical axis z and also have a longitudinal main extension along the first horizontal axis x, parallel to the gate trenches 4 and the diode trenches 14.

These separation trenches 20 are filled by a conductive region 22, in particular of polysilicon, which is separated from the substrate 2 by an insulating layer 23 which coats the internal walls of the same separation trenches 20.

In the example illustrated in Figure 1, two separation trenches 20 are arranged between a respective diode trench 14 and respective gate trenches 4 (of corresponding transistor cells); it is however apparent that other configurations are equally possible, with a different number of such gate trenches 4, diode trenches 14 and separation trenches 20.

Furthermore, in a manner not illustrated in detail, the separation trenches 20 may completely surround the diode trenches 14, for example having a ring shape around the same diode trenches 14.

During operation of the power device 1, the conductive regions 22 of these separation trenches 20 may be maintained at a suitable electrical potential, for example corresponding to the electrical potential of the "field-plate" conductive regions 9.

However, the present Applicant has realized that, at least in certain applications, operation of the diode element may be disturbed by external conditions, in particular by the biasing voltage of the drain terminal of the power device 1. For example, this condition may occur in case the power device 1 is used for automotive applications, as a power stage with its drain terminal which is electrically coupled to a motor vehicle battery.

There is therefore the possibility for the temperature sensing performed by the diode element to be affected by the aforementioned external disturbances, with resulting possible errors in the sensing signals provided and, consequently, with resulting malfunctions of the control logics which are based on the same sensing signals.

### SUMMARY

The present solution generally aims to overcome the limitations of the known systems.

According to the present solution, a transistor power device is therefore provided, as defined in the attached claims.

### BRIEF DESCRIPTION OF THE FIGURES

For a better understanding of the present invention, a preferred embodiment thereof is now described, purely by way of non-limiting example and with reference to the attached drawings, wherein:
- Figure 1 shows a schematic sectional view of part of a transistor device;
- Figure 2 is a schematic plan view of part of a transistor device, according to a first embodiment of the present solution;
- Figure 3A is a schematic cross-section of the device of Figure 2, taken along section line A-A';
- Figure 3B is a schematic cross-section of the device of Figure 2, taken along section line B-B';
- Figure 4 is a schematic plan view of part of a transistor device, in accordance with a second embodiment of the present solution;
- Figure 5A is a schematic cross-section of the device of Figure 4, takenalong section line A-A';
- Figure 5B is a schematic cross-section of the device of Figure 4, taken along section line B-B';
- Figures 6A-6C and 7A-7C are schematic cross-section views of part of the device of Figure 2, in subsequent steps of a corresponding manufacturing process; and
- Figures 8A-8C and 9A-9C are schematic cross-section views of part of the device of Figure 4, in subsequent steps of a corresponding manufacturing process.

### DESCRIPTION OF EMBODIMENTS

As will be described below, one aspect of the present solution envisages providing, in an embedded or integrated manner, within the same trench where the diode element is formed (for temperature sensing associated with the transistor power device), a protection or shield element, having the aim of protecting the diode element from external disturbances (for example, in relation to the battery voltage in case of automotive application).

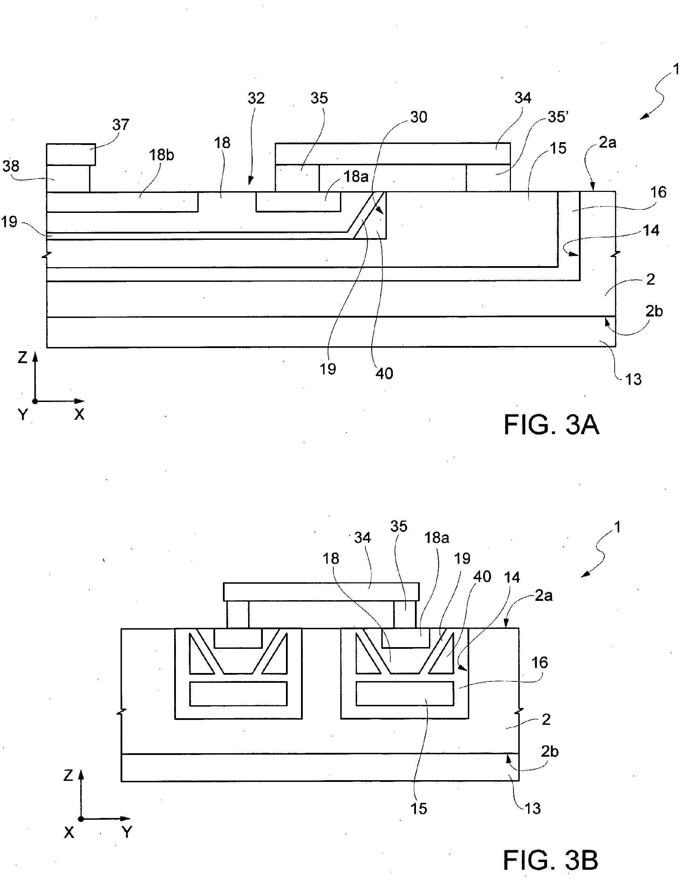

With reference to Figures 2, 3A and 3B, a first embodiment of a power device, again denoted by 1, of the transistor type provided with a diode element and the aforementioned protection or shield element is now described; to avoid repetitions, the general implementation of the power device 1 will not be described again, therefore reference may be made to what has been described in detail for Figure 1 (in general, similar elements will be referred to with the same reference numbers and will not be described again in detail).

In particular, Figure 2 shows in a schematic plan view only the diode trenches 14, in this case present in a certain number and parallel to each other along the first horizontal axis x, and an associated separation trench 20, having in the example a continuous ring extension around the same diode trenches 14. In particular, in the illustrated embodiment, the diode trenches 14 have end portions along the first horizontal axis x which connect to the ring of the separation trench 20.

As shown in Figure 3A, within each diode trench 14, which extends vertically in the substrate 2 of the power device 1, the filling conductive region 15 is present, in particular made of polysilicon, which also extends along the (lateral) walls of the diode trench 14, at end portions of the same diode trench 14 with respect to the first horizontal axis x .

This filling conductive region 15 is separated from the substrate 2 by the first insulating layer 16, for example of silicon oxide or nitride, which internally coats the lower and lateral walls of the same diode trench 14.

The filling conductive region 15 defines a residual opening, here denoted by 30, of the diode trench 14, which is substantially filled with the diode conductive region 18, also of polysilicon, which is arranged internally with respect to the aforementioned filling conductive region 15, at the front surface 2a of the substrate 2, being separated from the same filling conductive region 15 by the second insulating layer 19, for example also of silicon oxide.

In particular, this second insulating layer 19 covers lower walls of the aforementioned residual opening 30 defined by the filling conductive region 15.

As previously discussed, at least a first surface portion 18a of the diode conductive region 18 is doped with a doping of the first conductivity type (n); and at least a second surface portion 18b of the same diode conductive region 18 is doped with a doping of the second conductivity type (p), to respectively define a cathode terminal and an anode terminal of the diode element, here denoted by 32, integrated in the diode trench 14.

In particular, in Figure 3A a first metallization 34 is shown, defining the aforementioned cathode terminal of the diode element 32, which is arranged above the front surface 2a of the substrate 2, at a certain separation distance, and electrically contacts the first surface portion 18a of the diode conductive region 18, through a vertical contact element 35.

In the illustrated embodiment, the aforementioned first metallization 34 also contacts the filling conductive region 15, through a further vertical contact element 35', so that this filling conductive region 15 is at the same electrical potential as the aforementioned cathode terminal.

In the same Figure 3A, a second metallization 37 is also shown, defining the aforementioned anode terminal of the diode element 32, also arranged above the front surface 2a of the substrate 2, at a certain separation distance, and which electrically contacts the second surface portion 18b of the diode conductive region 18, through a respective vertical contact element 38.

According to one aspect of the present solution, the aforementioned protection or shield element, here denoted with 40, is also formed within the diode trench 14.

This protection element 40 is made of a conductive material, in particular doped polysilicon.

The protection element 40 is formed at the lateral walls of the aforementioned residual opening 30 defined by the filling conductive region 15, being therefore generally arranged between the diode conductive region 18 (being separated therefrom by the second insulating layer 19) and the substrate 2, thus forming a screen or shield element for the diode element 32 in relation to the same substrate 2.

For example, this protection element 40 has a maximum width in the horizontal plane xy, in a direction transversal to the vertical axis z, at a greater distance from the front surface 2a of the substrate 2 (generally having a wedge shape, tapered towards the same front surface 2a), for example comprised between 100 nm and 200 nm.

In greater detail, in the direction of the first horizontal axis x (as shown in the aforementioned Figure 3A), the protection element 40 is arranged between the second insulating layer 19 and the filling conductive region 15, being directly in contact with the same filling conductive region 15. Consequently, the protection element 40 is set at the same electrical potential as the filling conductive region 15, which, in the example previously discussed, also corresponds to the potential of the cathode terminal of the diode element 32.

As shown in Figure 3B, the same protection element 40, in the direction of a second horizontal axis y (orthogonal to the first horizontal axis x and defining, with the same first horizontal axis x, the horizontal plane xy), is arranged between the second insulating layer 19 and the substrate 2 (in particular between the second insulating layer 19 and the first insulating layer 16), at upper portions of the lateral walls of the diode trench 14.

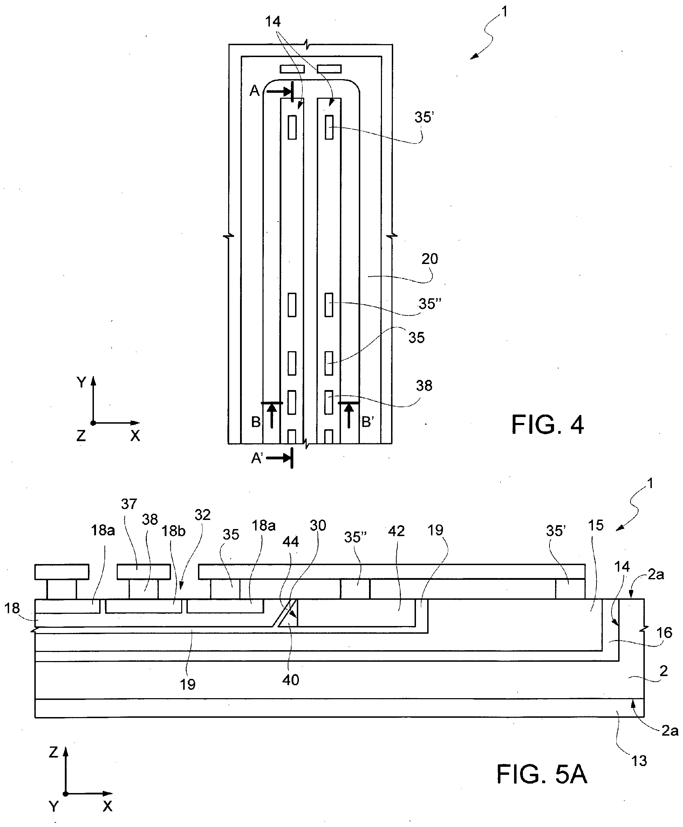

With reference to Figures 4 and 5A -5B, a second embodiment of the power device 1 is now described, which differs from the first previously described embodiment due to a different arrangement and integrated implementation of the protection element 40 within the respective diode trench 14.

In the example illustrated in Figure 4, two diode trenches 14 are shown surrounded by a separation trench 20, having a ring shape in the horizontal plane xy (again, however, different arrangements and configurations may obviously be envisaged, for example as to the number of the aforementioned diode trenches 14 and separation trenches 20).

Unlike what has been discussed for the first embodiment, generally this second embodiment envisages, for forming the diode region, an etching in the gate region of the power device 1; as a result, the insulation with the substrate 2 is in this case of a smaller thickness on the internal lateral walls of the residual opening 30 (in particular along the direction of the second horizontal axis y) with respect to the thickness of the first insulating layer 16; in fact, in this case this insulation is a function of the thickness of the gate oxide.

As shown in Figure 5A (referring to the cross-section along the first horizontal axis x), in this embodiment, a gate conductive region, denoted here by 42, for example also of polysilicon (in particular being formed with the same material as the gate regions 6) is therefore present within the diode trench 14.

This gate conductive region 42 is separated from the filling conductive region 15 by the insulating layer 8 (defined in the aforementioned Figure 1 and which corresponds to the gate oxide, having a reduced thickness).

The gate conductive region 42 also contributes in this case to defining the aforementioned residual opening 30 within the same diode trench 14.

The protection element 40 is arranged in this case in contact with this gate conductive region 42; in this embodiment, the protection element 40 is therefore biased by biasing the same gate conductive region 42.

In particular, as shown in Figure 5A, the first metallization 34, defining the cathode terminal of the diode element 32, in addition to electrically contacting the first surface portion 18a of the diode conductive region 18, through the vertical contact element 35 and the filling conductive region 15 through the further vertical contact element 35', also contacts the aforementioned gate conductive region 42 through yet a further vertical contact element 35".

The protection element 40 is again separated from the diode conductive region 18 by the second insulating layer 19, of dielectric material, for example of silicon oxide or nitride. The same protection element 40 is arranged, along the first horizontal axis x, between the gate conductive region 42 and the aforementioned second insulating layer 19.

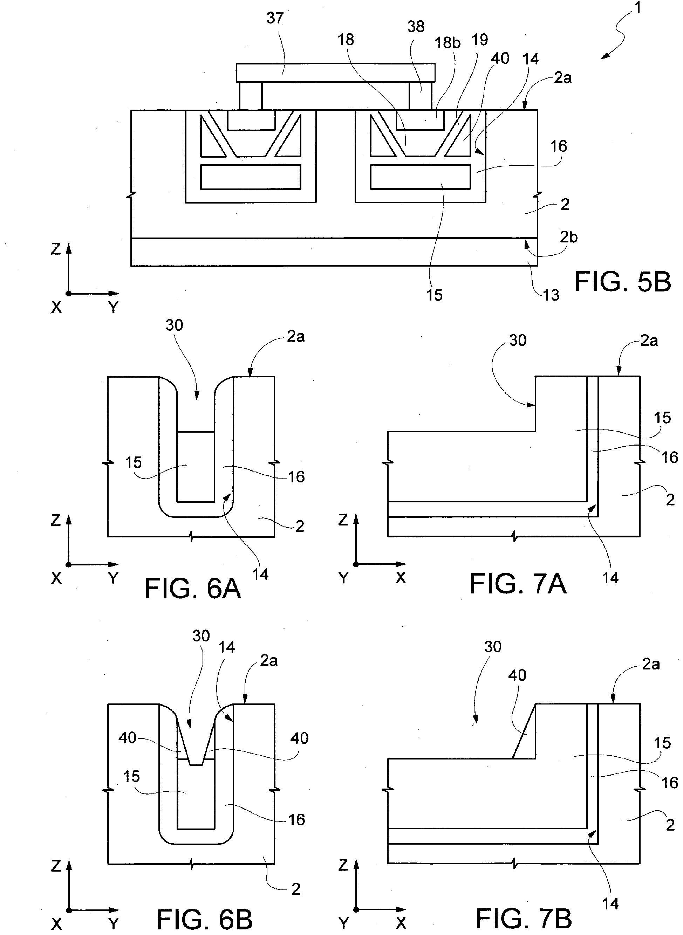

As shown in Figure 5B (referring to the direction along the second horizontal axis y), unlike the solution described in Figure 3B, the protection element 40 is insulated both with respect to the conductive region 15 and with respect to the substrate 2, through the aforementioned insulating layer 8 and through the first insulating layer 16.

It should be noted that Figure 5B also shows the second metallization 37, defining the anode terminal of the diode element 32, which electrically contacts the second surface portion 18b of the diode conductive region 18, through the respective vertical contact element 38.

With reference to schematic Figures 6A-6C (corresponding to the cross-section along the second horizontal axis y) and 7A-7C (corresponding to the cross-section along the first horizontal axis x), a possible manufacturing process of the protection element 40 is now described, as regards the aforementioned first embodiment (it should be noted that, for simplicity of explanation, only the process steps relating to the manufacturing of the protection element 40 are described).

In particular, a first step, shown in Figures 6A and 7A, relates to the trench etching of the filling conductive region 15 previously formed within the diode trench 14, for the formation of the residual opening 30. In a possible implementation, this etching is performed for a thickness in the direction of the vertical axis z comprised between 0.3 µm and 1 µm, for example of about 0.7 µm.

As shown in Figure 7A, in the direction of the first horizontal axis x, the residual opening 30 is delimited by remaining wall portions of the filling conductive region 15, which are not involved in the trench etching. As shown in Figure 6A, in the direction of the second horizontal axis y, the same residual opening 30 is instead delimited by the first insulating layer 16, which internally coats the walls of the diode trench 14.

Subsequently, the manufacturing process envisages the formation of the protection element 40 at the internal walls of the aforementioned residual opening 30.

In particular, as shown in Figures 6B and 7B, a deposition of polysilicon is performed (with a thickness comprised between 100 nm and 200 nm), suitably doped, for example with phosphorus atoms, with a doping dose for example of about 10²¹ atoms/cm³.

Subsequently, an etching (so-called "etch back") of the previously deposited polysilicon is performed, for example with an etching mixture Cl/HBr/O₂ and end-point on the first insulating layer 16 (i.e., on the silicon oxide or nitride which forms the same first insulating layer 16).

This etching leads to definition of the protection element 40 on the walls of the residual opening 30, with its wedge shape, tapered towards the front surface 2a of the substrate 2.

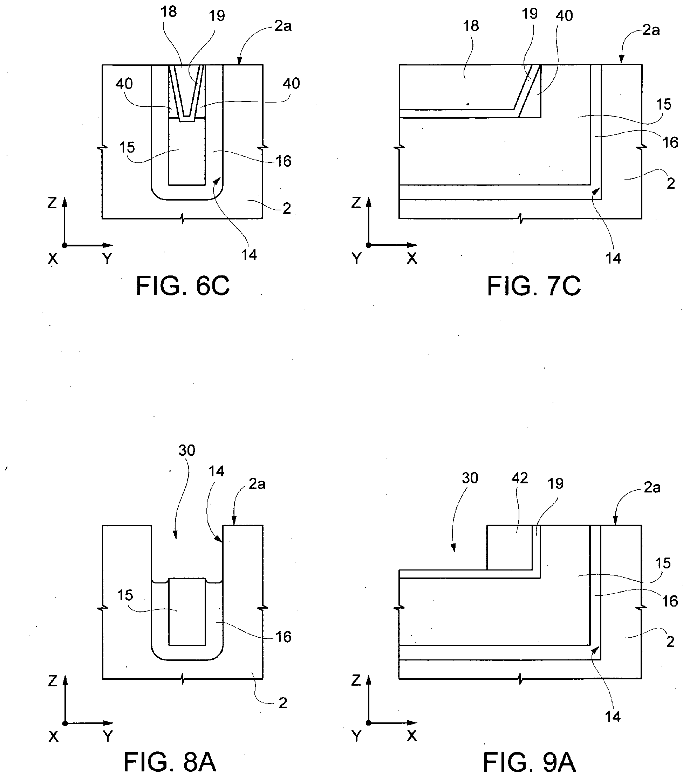

As shown in Figures 6C and 7C, the manufacturing process then proceeds with the following process steps: growing the second insulating layer 19 within the residual opening 30 and on the protection element 40 previously formed, for example with a thickness of 30 nm, by ISSG (In Situ Steam Generation) at a temperature of 1150 °C; filling the residual opening 30 by forming the diode conductive region 18, of undoped polysilicon, for example with a thickness comprised between 400 nm and 5000 nm; planarizing by CMP (Chemical Mechanical Polishing) the same diode conductive region 18; defining the first surface portions 18a and the second surface portions 18b of the aforementioned diode conductive region 18 by implanting dopant, respectively of the first conductivity type (n), for example with arsenic atoms with a doping dose of about 10¹⁵ atoms/cm² and implant energy of 30 keV, and of the second conductivity type (p), for example with boron atoms with a doping dose of about 10¹⁵ atoms/cm² and implant energy of 7 keV, to respectively define the cathode and the anode of the diode element 32.

The manufacturing process is substantially similar (and therefore it is not described in detail again) for the second embodiment, as shown in Figures 8A-8C (relating to the cross-section along the second horizontal axis y) and 9A-9C (relating to the cross-section along the first horizontal axis x).

It is again underlined that, unlike what has been discussed for the first embodiment, the opening of the diode region envisages etching in the gate region; therefore the insulation from the substrate 2 is of a smaller thickness on the internal lateral walls of the residual opening 30. Furthermore, in this case, the manufacturing process envisages that the insulating layer 8, with a smaller thickness, defines the insulating layer between the gate conductive region 42 and the filling conductive region 15. The inside of the diode trench 14 is insulated from the substrate 2 also by the first insulating layer 16 (as also shown in Figure 9A).

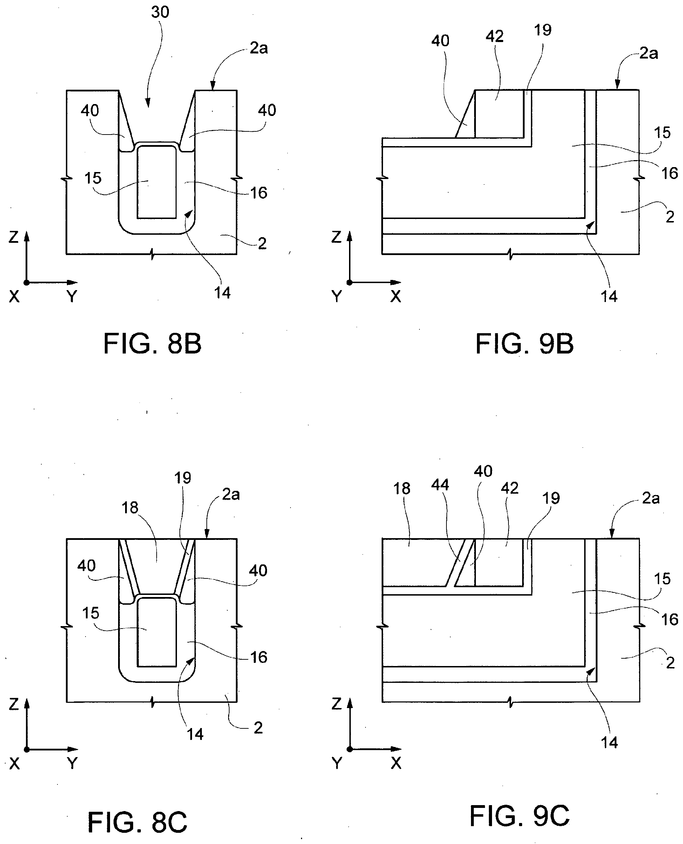

As shown in Figures 8B and 9B, the protection element 40, when it is formed, in this case in contact with the gate conductive region 42, is not directly in contact, neither laterally nor downwardly, with the filling conductive region 15.

As shown in Figures 8C and 9C, the previously described step (of growing the dielectric material by ISSG at a temperature of 1150 °C) is then performed for the formation of the second insulating layer 19.

The manufacturing process then proceeds with steps similar to those previously described, in particular for filling the aforementioned residual opening 30 with the diode conductive region 18 and defining the diode element 32 starting from this diode conductive region 18.

The advantages of the proposed solution are clear from the preceding description.

In any case, it is underlined that this solution advantageously allows forming, integrated within the diode trench of the transistor power device, a protection element which protects the diode element operating as a temperature sensor, from external disturbances (for example from disturbances coming from the drain voltage of the same transistor power device).

Advantageously, this protection element does not envisage steps of a manufacturing process substantially different from a standard manufacturing process of the power device, with a resulting minimum increase in manufacturing times and costs.

Finally, it is clear that modifications and variations may be made to what has been described and illustrated herein without thereby departing from the scope of the present invention, as defined in the attached claims.

In particular, it is underlined that the described solution may generally find advantageous application for any power device in which formation, in an integrated manner, of a diode temperature sensor element is required (for example for different types of vertical-trench MOSFET devices).

## Claims

1. A transistor power device (1), comprising:
a substrate (2) of semiconductor material, having a front surface (2a) with extension in a horizontal plane (xy) and a rear surface (2b), opposite with respect to the front surface (2a) along a vertical axis (z), transverse to the horizontal plane (xy);
at least a first trench (4), which extends starting from the front surface (2a) within the substrate (2) in the direction of the vertical axis (z) and has a longitudinal main extension along a first horizontal axis (x) of the horizontal plane (xy), a gate region (6) of a transistor cell of said power device (1), of a conductive material, being arranged in a surface portion of the first trench (4);
at least a second trench (14), which extends starting from the front surface (2a) within the substrate (2) in the direction of the vertical axis (z), parallel to the first trench (4), a first conductive region (18) being arranged at a surface portion of the second trench (14), wherein at least a first surface portion (18a) of said first conductive region (18) is doped with a first conductivity type (n) and at least a second surface portion (18b) of said first conductive region (18) is doped with a second conductivity type (p), to respectively define a cathode terminal and an anode terminal of a diode element (32), integrated in said second trench (14),
**characterized by** further comprising a protection element (40) of a conductive material, integrated within the second trench (14), arranged between said first conductive region (18) and said substrate (2), configured to define a shield element for the diode element (32) with respect to the substrate (2).

2. The device according to claim 1, wherein said first (18a) and second (18b) surface portions of the first conductive region (18) are aligned along the first horizontal axis (x) and are separated along said first horizontal axis (x) by a separating surface portion of the first conductive region (18); and wherein said second trench (14) is filled at the bottom by a second conductive region (15), which extends also at lateral walls of said second trench (14) at end portions thereof along the first horizontal axis (x) and is separated from the substrate (2) by a first insulating layer (16), which internally coats the walls of the second trench (14); wherein said first conductive region (18) is arranged internally with respect to the second conductive region (15), from which it is separated by a second insulating layer (19); said protection element (40) being arranged, in the direction of said first horizontal axis (x), between said second insulating layer (19) and said second conductive region (15) and, in the direction of a second horizontal axis (y), orthogonal to the first horizontal axis (x), between said second insulating layer (19) and said substrate (2) at the lateral walls of said second trench (14).

3. The device according to claim 1 or 2, wherein said protection element (40) is made of polysilicon and has a wedge shape tapered towards said front surface (2a).

4. The device according to any of the preceding claims, further comprising a first metallization (34), arranged above the front surface (2a) of the substrate (2), which electrically contacts the first surface portion (18a) of the first conductive region (18), through a vertical contact element (35); wherein said first metallization (34) further contacts said protection element (40) through a further vertical contact element (35',35") so that it is at a same electrical potential as said first surface portion (18a).

5. The device according to any of the preceding claims, wherein said second trench (14) is filled at a bottom by a second conductive region (15), which is separated from the substrate (2) by a first insulating layer (16); wherein said second conductive region (15) defines a residual opening (30) of the second trench (14), wherein said first conductive region (18) is arranged, insulated from the second conductive region (15).

6. The device according to claim 5, wherein said protection element (40) is arranged at a lateral wall of said residual opening (30); and wherein said first conductive region (18) is separated from said protection element (40) by a second insulating layer (19).

7. The device according to claim 6, wherein said protection element (40) is arranged in contact with said second conductive region (15), interposed between said second insulating layer (19) and said second conductive region (15).

8. The device according to claim 6 or 7, wherein a third conductive region (42) is present within the second trench (14), which contributes to defining said residual opening (30) within the second trench (14); wherein the protection element (40) is arranged in contact with said third conductive region (42), interposed between said second insulating layer (19) and said third conductive region (42).

9. The device according to claim 8, comprising a first metallization (34) which electrically contacts said second conductive region (15) and said third conductive region (42) through a respective vertical contact element (35', 35").

10. The device according to claim 8 or 9, wherein said third conductive region (42) is separated from the second conductive region (15) by a third insulating layer (8).

11. The device according to any of the preceding claims, further comprising at least a third trench (20), which extends starting from the front surface (2a) within the substrate (2) in the direction of the vertical axis (z) and has a longitudinal main extension along the first horizontal axis (x) parallel to said first and second trenches (4, 14); wherein said third trench (20) is filled by a respective conductive region (22), which is separated from the substrate (2) by a respective insulating layer (23) which coats the internal walls of said third trench (20).

12. The device according to claim 11, wherein a conductive region (9) is present within a deep portion of the first trench (4) arranged below the surface portion, the conductive region (9) being arranged below the gate region (6) and electrically insulated from the gate region (6); wherein said conductive region (9) is configured to be biased at a same electrical potential as said respective conductive region (22) within said third trench (20).

13. The device according to any of the preceding claims, comprising a plurality of transistor cells, each of which comprises: a respective first trench (4) with a respective gate region (6) therewithin; at least a body region (10), arranged laterally to the first trench (4), in proximity to the front surface (2a) of the substrate (2) and separated from the gate region (6) by a gate oxide region (8); and at least a source region (12), arranged within the body region (10), at said front surface (2a).

14. A process for manufacturing a transistor power device (1), comprising:
providing a substrate (2) of semiconductor material, having a front surface (2a) with extension in a horizontal plane (xy) and a rear surface (2b), opposite with respect to the front surface (2a) along a vertical axis (z), transverse to the horizontal plane (xy);
forming at least a first trench (4), which extends starting from the front surface (2a) within the substrate (2) in the direction of the vertical axis (z) and has a longitudinal main extension along a first horizontal axis (x) of the horizontal plane (xy), a gate region (6) of a transistor cell of said power device (1), of a conductive material, being arranged in a surface portion of the first trench (4);
forming at least a second trench (14), which extends starting from the front surface (2a) within the substrate (2) in the direction of the vertical axis (z), parallel to the first trench (4), a first conductive region (18) being arranged at a surface portion of the second trench (14), wherein at least a first surface portion (18a) of said first conductive region (18) is doped with a first conductivity type (n) and at least a second surface portion (18b) of said first conductive region (18) is doped with a second conductivity type (p), to respectively define a cathode terminal and an anode terminal of a diode element (32), integrated in said second trench (14),
**characterized by** further comprising forming a protection element (40) of a conductive material, integrated within the second trench (14), arranged between said first conductive region (18) and said substrate (2), configured to define a shield element for the diode element (32) with respect to the substrate (2).

15. The process according to claim 14, wherein said first (18a) and second (18b) surface portions of the first conductive region (18) are aligned along the first horizontal axis (x) and are separated along said first horizontal axis (x) by a separating surface portion of the first conductive region (18); further comprising:
filling said second trench (14) at a bottom with a second conductive region (15), which is separated from the substrate (2) by a first insulating layer (16) and extends also at lateral walls of said second trench (14) at end portions thereof along the first horizontal axis (x); and etching said second conductive region (15) to define a residual opening (30); wherein forming said protection element (40) comprises depositing a conductive material within said residual opening (30) and performing an etching of said conductive material for defining the protection element (40) at a lateral wall of the residual opening (30);
after forming the protection element (40), growing a second insulating layer (19) within the residual opening (30) and on the protection element (40); forming the first conductive region (18) within the residual opening (30); and defining said first and second surface portions (18a, 18b) of said first conductive region (18) by implanting dopant, respectively of the first and the second conductivity types (n, p) to define said diode element (32);
said protection element (40) being arranged, in the direction of said first horizontal axis (x), between said second insulating layer (19) and said second conductive region (15) and, in the direction of a second horizontal axis (y), orthogonal to the first horizontal axis (x), between said second insulating layer (19) and said substrate (2) at the lateral walls of the second trench (14).
